# EUROPEAN PATENT APPLICATION

(11) **EP 3 315 976 A1**
(43) Date of publication of application: **02.05.2018**
(21) Application number: 17382716.3
(22) Date of filing: 25.10.2017
(51) Int. Cl.: G01R 11/24, G01R 11/04, G01R 11/00

(54) **SAFETY ARRANGEMENT FOR CONNECTING ELECTRICAL AND DIGITAL METERS**

(30) Priority: 26.10.2016 ES 201631286
(71) Applicant: Mezcua Moreno, Ildefonso, 08031 Barcelona (ES)
(72) Inventor: Mezcua Moreno, Ildefonso, 08031 Barcelona (ES)
(74) Representative: Espiell Volart, Eduardo Maria

(57) **Abstract**

The connectors block is a body of any material having dielectric properties suitable for the voltage used in the low voltage wirings that is distributed in a front preferably prismatic part and a likewise prismatic rear part, of the front part, emerging from its top base perpendicularly to the terminals two phases and neutral points, one of which assigned to the neutral, can be moved to the right and to the left of the said base, thanks to being able to move in the sliding slot being therefore able to adapt itself to the female terminals located in boxes in the case of an analog meter and, in the case of a digital meter, the male terminals of the connectors block being cancelled by means of the block protecting unit of the said terminals. In the body and between the front part and the rear part of the connectors block there are lateral slots, useful to fit them. In the connectors blocks and at its front part and its top base cavities open by their top part exist, in which are housed screwed tubular conventional connectors with exit by the vertical rear base trapped at the phases of the property connection and from its section of individual tap.

## Description

### OBJECT OF THE INVENTION

More concretely the invention refers to a safety arrangement for connecting electrical meters, designed with the aim to avoid the manipulation of the said connection between phases and neutral points and the terminals arranged in the kW meters of the companies supplying electricity.

### STATE OF THE ART

By the utility model of the same holder n° 9600028 the object of which is a "Device for connecting electrical meters ", as its first independent claim states a block of insulating material is known having an elongated shape and a L-shaped cross section, forming a first part that remains ready to fit in the lower central opening of the board penetrating in the back chamber it defines and in which connecting elements are occluded provided for making possible the connection of the meter input and output conductors and a second part that remains applied against the front face of the board, from the top base of which metal rods orthogonally emerge as connecting plugs, each of them is connected to one of the said connecting elements , that remain ready to be fit in the holes provided at the lower part of the meter for the conductors input and to be gripped in these holes, securing the connection of the said meter to the related circuits.

The implementation of the said model reduced the number of bridged meters and, therefore the number de kilowatts defrauded from the electrical companies supplying power, as it makes difficult to manipulate the conductors coming from the section of intellectual tap, in order that they do not pass within the meter and thus their reading does not correspond to the kilowatts consumed by the user with the subsequent loss of income for the said companies.

However the implementation of meters within the cabinets disclosed certain incommodities when installing them, in the screens that, immobilized in the respective cabinets, serve as support to the current meters, with its terminals box and that are incorporated to the said block of insulating material.

### OBJECT OF THE INVENTION

To overcome the said incommodities making easier the implementation in new screens, or in other existing screens, of the block of insulating material modified so that its implementation to as well existing or new screens is easier, solve the problem of adaptability of a single block to different types of terminals, chiefly the different gaps between them and the different types of meters, all of them incorporating female terminals to receive the preceding male terminals, included in the box situated at the lower part of the either analog or digital meters.

### DESCRIPTION OF THE INVENTION

The invention disclosed implements a series of improvements to the object of the utility model of the same above mentioned holder, modifying its architecture as well as the screens existing in the market, most of which are no longer made of wood as they used to be supporting the containers in many old buildings and that with the emergence of the digital meters became obsolete technically speaking, being gradually replaced by screens of dielectric and fire retardant plastic materials the body of which, that of the said screen, is provided with slots and holes allowing their quick installation on the back of the meters cabinets, as well as to easily incorporate as well electrical and/or digital meters having different geometries, without it is required to manually modify the body of the said screens.

Conventional screens show a rather rectangular perimeter consistent with the geometry of the cabinet and of the meters and, therefore the supplying companies have to previously homologate all of them.

Their corners are chamfered and show holes through which stubs pass emerging from the base of the meter, avoiding the screen is moved or manipulated from behind thereof while they prevent the entrance of tools and hands in the cavity formed by the body of the screen and the base of the cabinet adjacent to the wall the said manipulations tending to separate the conductors of the terminals from the meter and the block of insulating material that will be thereafter named connectors block that will continue to be of insulating material, however its body is provided according to one of the characteristics de la invention at its vertical lateral bases, with slots allowing to couple the body of the connectors bock with a recess provided at the lower base of the screen, allowing to insert through the slots provided in the screens the connectors block in a vertical bottom upwards motion and when this block is immobilized in the body of the screen, sealing the joint of the screen and block with the known conventional means.

According to another characteristic of the invention, the connectors block has been internally modified in order that the male terminal corresponding to the neutral point or points of the conductor can be moved on the top face of the said block, achieving that the said block is universal and with only moving it to the right or to the left in a sliding slot provided on the upper base of the body of the block, it can receive the female terminals arranged in the box of the meters at different distances depending on the meters.

In addition and according to another of the objects of the invention, the connectors block of the preceding paragraph, the said neutral point movable in a sliding slot, can be comprised of a cylindrical sheath within which the terminal is introduced, in this case the neutral, but the said terminal will be detachable, that means that when the connectors block is operative the said terminal threaded by its lower part and the same as the rest of terminals remains screwed in the connectors, but when the meter is withdrawn, the said detachable neutral terminal is unscrewed and the connectors blocks is left with only two terminals and a sheath without voltage.

According to another of the objects of the invention, it incorporates a terminals protecting unit that acts when the companies withdraw the meter, leaving the terminals uncovered, a moment when the said protecting unit, basically a rather prismatic block provided with blind holes, in correspondence with the alignment of the said terminals is placed on the connectors block, leaving the terminals both concealed and protected , by means of the said protecting unit, to which it is joined by means of sealing to the connectors block avoiding that unscrupulous third parties may be connected to the current when the meters are withdrawn.

Other details and characteristics will become apparent along the description given below in which it is referred to figures attached to this specification, in which is shown for description but non-limiting purpose an embodiment of the invention, that can be implemented with different types of materials and sizes provided that they are suitable for the functions to which the invention is designed.

### DESCRIPTION OF THE FIGURES

A list of the different parts of the invention is given below that appear in the following figures which are identified with the following numbers; (10) cabinet, (11) screen, (11.1) chamfered vortices, (11.2) holes in the vortices (11.1), (11.3) recess, (12) analog meter (13) reading slot, (14) disk slot, (15) box, (16) connectors block, (16.1) front part, (16.2) rear part, (16.3) terminals, (17) screw, (18) reading slot, (19) digital meter, (20) signalling unit, (21) box, (22) body of the cabinet (10), (24) slots in the screen (11), (25) slots in the screen (11), (26) slots in the connectors block (16), (27) body of the block (16), (28) top base of the front part (16.1), (29) sliding slot in the base (28), (30) top base of the rear part (16.2), (31-32-33) cavities in the top base (30), (34-35-36) cavities in the base (38), (38) vertical rear base of the front part (16.1) of the connectors block (16), (39) offset, (40) terminals block protecting unit (16.3), (41) top base of the protecting unit (40), (42) lower base of the protecting unit (40), (43- 44) lateral vertical bases of the protecting unit (40), (45) larger top base of the protecting unit (40), (46-47) blind holes in the body (52) of the protecting unit (40), (48) through hole in the body (52) of the protecting unit (40), (49) blind holes, (50-51) blind holes of the body (52), (52) body of the terminals protecting unit (40), (53-54) larger lateral bases of the body (52) of the protecting unit (40), (55) screw, (56) stubs (58) sheath.

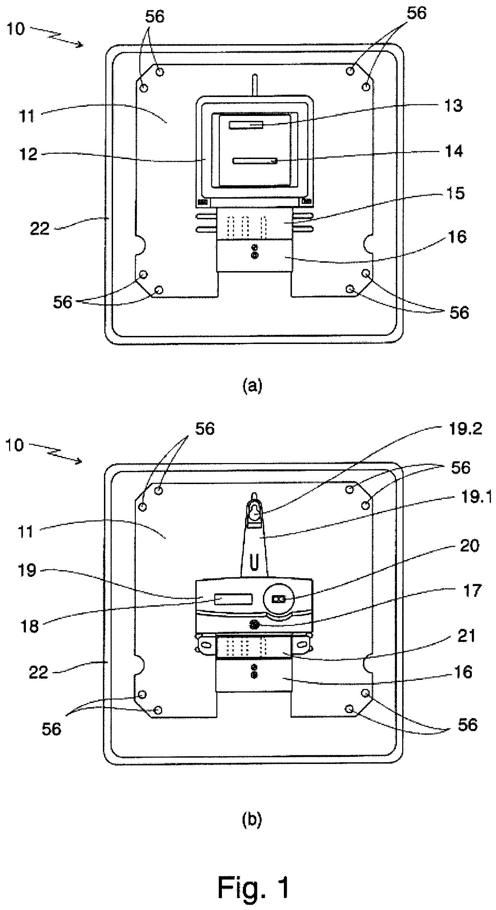

Figure n° 1a is a front elevation view of the cabinet (10) without its front cover preferably of translucent material and, within it, the screen (11) and the meter (12) and, at its lower part ,that of the analog meter, the box (15) and the connectors block (16) which in normal conditions (15-16), remain protected by the relative cover, not shown in this figure to best appreciate the characteristics of the invention.
Figure n° 1b is a front elevation view of the cabinet (10) without its front cover and within it, the screen (11) and the digital meter (19) and, at its lower part, that of the meter (19), the box (21) and, the connectors block (16) protected (16-21) with the relative cover not shown in this figure.

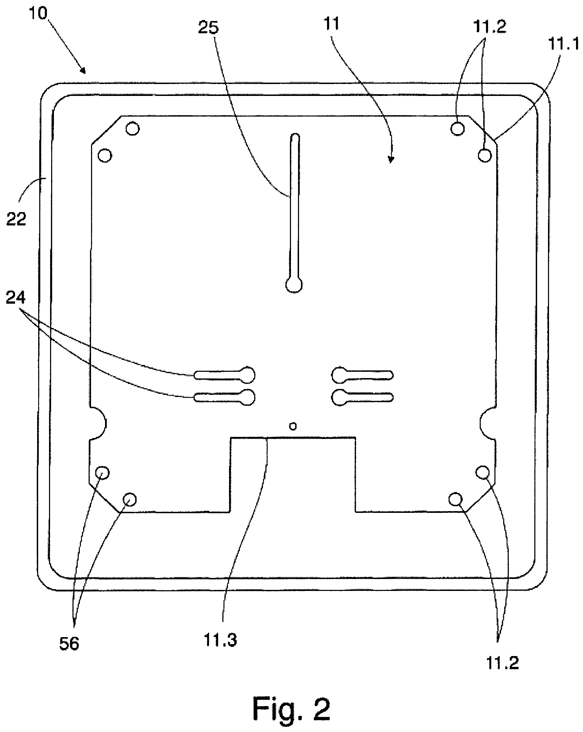

Figure n° 2 is a front elevation view of the cabinet (10) in which body (22) the screen (11) has been mounted having chamfered edges (11.1) close to which the holes (11.2) have been provided in which the stubs (56) are imbedded , that is the one used with slight variations for installing either analog (12) or digital (19) meters and, at the lower part of the screen (11) the recess (11.3) and, in the body of (11) different slots (24-25) depending on their use in order to be able to fasten the screen (11) to the meter (12) or the meter (19).

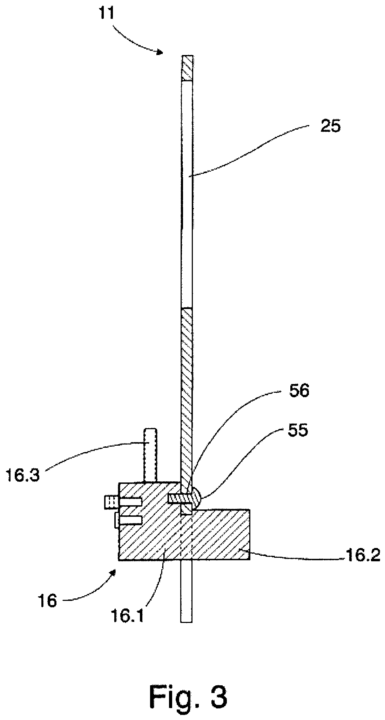

Figure n° 3 is a cross section elevation view of the screen (11), at the lower part of (11) the connectors block (16) that is incorporated to the said screen (11) by means of the slots (26) provided at the lateral bases thereof, the block (16) been fastened on the screen (11) by means of the screw (55).

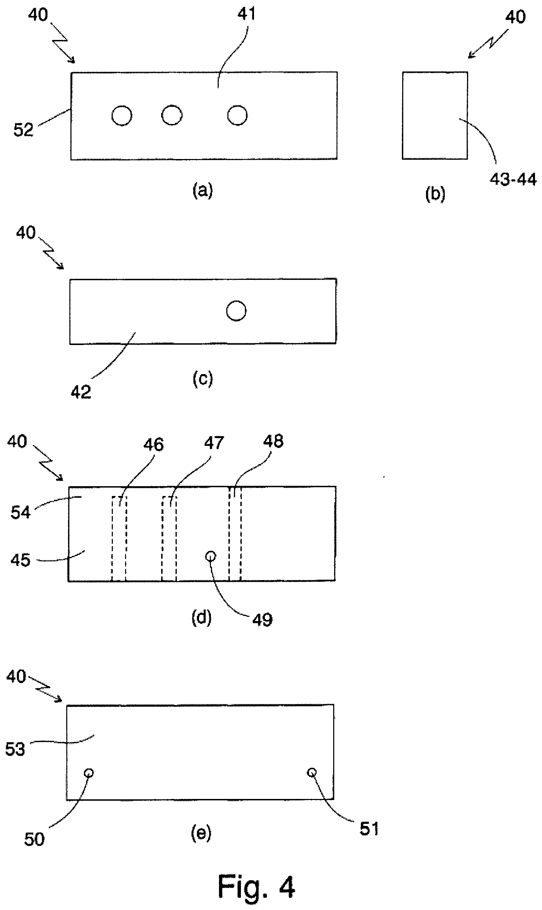

Figure n° 4 is (a) a top plan view of the terminals protecting unit (40) by its top base (41), (b) is a side elevation view of the terminals protecting unit (40) by its lateral bases (43-44), (c) is a top elevation view of the terminals protecting unit (40) by its base (42), (d) is a front elevation view by one of its larger lateral bases (54) of the connectors protecting unit (40) and, (e) is a side elevation view by one of its larger bases (53) of the connector of terminals (40).

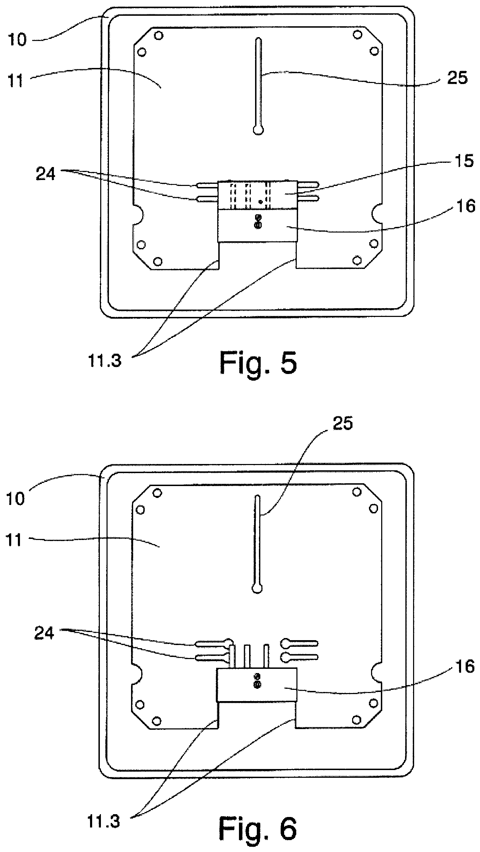

Figure n° 5 is a front elevation view of the cabinet of the meters (10) without meter, with the screen (11) incorporated by the suitable means to the rear base thereof and in the lower part of the said screen (11), the connectors block (16) with the terminal protecting unit (16) of the body (40) coupled to the male terminals (16.3).
Figure n° 6 is a front elevation view of the cabinet of the meters (10) with the screen (11) incorporated by the suitable means to the rear base thereof and, at the lower part (11) of the connectors block (16).

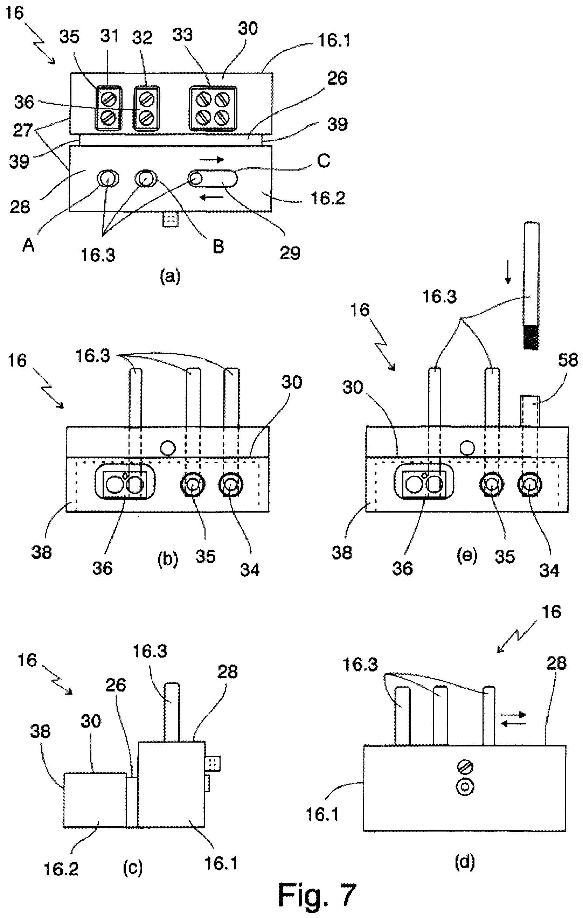

Figure n° 7 is (a) a top plan view of the connectors block (16), (b) is a front elevation view by its rear part of the connectors block (16) and, (c) is a side elevation view of the connectors block (16), (d) is a rear elevation view of the front part (16.1) of the block (16) and (e) is a view of an embodiment alternative to that shown in (b) in which the connectors block incorporates a sheath (58) capable to place or vertically withdraw by screwing or unscrewing one of the terminals (16.3).

### DESCRIPTION OF AN EMBODIMENT OF THE INVENTION

In one of the preferred embodiments of the invention and as it can be seen in the figures N° 1a and 1b, it shows the safety arrangement disclosed in a cabinet for meters (10) which incorporates the screen (11) immobilizing the said screen (11) at the base of the said meter (10) and, on the said screen (11) the either analog or digital meter is linked (12) and (19) respectively and, at the lower part of the said meters the boxes (15-21) with connectors block (16), which is comprised as it can be seen in Figures n° 3 and 4 of two bodies, such as the front part (16.1) and the rear part (16.2).

At the lower base of the meters (12-19) are incorporated by the suitable means, the boxes (15) y (21) respectively, in some cases the box forming part of the body of the meter and, to these later the connectors block (16) . The said blocks (16) show a front part (16.1) that remains ahead of the screen (11), and at the rear part (16.2) that is situated behind the said screen (11) therefore it is not possible that the fraudsters to move the conductors coming from the section of individual tap, from its connection to the meters in general to the wiring without passing by the reading meter.

The connectors block (16) as it can be seen in Figure n° 7 in its views (a), (b), and (c), is a body (27) of any material having dielectric properties suitable for the voltage used in the low voltage wirings , for example 125, 220 and 380 volts, with the essential characteristic to be single-body, although and as it has been disclosed above, the said body (27) is distributed in one front part, preferably prismatic (16.1) and a rear part also prismatic (16.2).

From the front part (16.1) and its top base (28) as it can be seen in Figure n° 7 (d), are perpendicularly emerging the terminals (16.3), two phases and neutral points , one of which, the c, is designed to the neutral point, can be moved to the right and to the left of the said base (28) as indicated by the relative arrows thanks to a sliding slot (29) with which it can be fit to the female terminals located in the boxes (15) in the case of an analog meter and, (21) in the case of a digital meter with the said terminal c being adapted to the gap between the said female terminals A and B, alternatively and as it can be seen in Figure n° 7 (e) and perpendicular to the base (28) of the block (16) a sheath (58) is placed, that reaches the connector (34), so that one of the terminals (16.3) with its lower threaded part can be screwed or unscrewed from the said connector (34), so that when the meter is withdrawn, the terminal (16.3) is likewise withdrawn from the connector (34) only the sheath (58) and the other two terminals 16.3 remaining, thus it is not possible to reset the voltage.

The front part (16.1) and from its top base (28) as shown in Figure n° 7 (a) cavities open by their top part (31-32- 33) exist, in which are housed conventional connectors (34-35-36) with exit by the vertical rear base (38). The connectors (34-35-36) are simple tubular ducts provided with holes in which respective screws are screwed trapping the conductive part of the phases coming from the connection of the property and from its section of individual tap, building or the like and from its section of individual tap.

The front part (16.1) of the connectors block (16) and the rear part (16.2) show lateral slots (26) allowing to fit the block (16) in the screen (11) by its recess (11.3), as it can be seen in Figure n° 3.

When for whatever reason a meter is withdrawn from the cabinet meters (10) and, to avoid any manipulation according to another characteristic of the invention, the male terminals (16.3) of the connectors block (16) are cancelled by superposing the protecting block unit (40), provided with the related blind holes and it is located atop of the block (16), sealing thereafter the block (16) with the block protecting unit (40) immobilizing the joint of both of them.

The block protecting unit (40) as it can be seen in Figure n° 4 shows a prismatic body (52) provided with blind holes (46, 47, 48) in which the terminals (16.3) of the connectors block (16), can be housed the block protecting unit (40) and the connectors block (16) being able to be sealed.

In the technical sector of the invention, it is known that the conductors coming from the transformation station, after passing through the related transformer, supply the respective low voltage consumption points by means of the different conductors with phases and/or neutral point, that run preferably although not exclusively through buried or aerial supported conductors or overlapping the facades up to the entrance of the said consumption points, being connected to the respective apartments, flats, premises and their analog or digital meter.

Since many years ago, the power supplying companies are aware of small or big frauds the aim of which is to defraud the consumption of the said electricity they supply, for which the fraudsters use a variety of means that distort downwards the consumption measured by the said meters, the means mostly used because of their simplicity being, disconnecting the conductors from the section of individual tap, from the terminals of the meter, generally located at the front part of the meter and, in its lower part and, thereafter connecting them directly after the meter, the meter therefore does not detect any consumption with the subsequent economic losses for the said supplying companies.

According to a characteristic of the invention, the connection of the section of individual tap, is connected to the terminals and/or connectors of the meters (12-19) behind the screen (11) as it can be seen in Figure n° 3, thus the arrangement disclosed makes very difficult one of the most frequent meter cheating actions against the meter, when unscrupulous people withdraw the cables of the connectors of the meter situated according to the state-of-the-art in a front position and, connect them directly to the individual line but without passing through the meter, therefore the meter does not mark the kilowatts consumed and, subsequently the invoicing is impaired by the said undue connection, with the subsequent economic losses for the power supplying companies.

This invention being sufficiently described in correspondence with the figures attached, it is easy to understand that any change of details can be carried out in it that are deemed convenient provided that the essence of the invention is not altered that is summarized in the following claims.

## Claims

1. SAFETY ARRANGEMENT FOR CONNECTING ELECTRICAL AND DIGITAL METERS comprised of a cabinet for meters of dielectric material preferably of plastic, provided with a front transparent cover incorporating within the said cabinet a screen of dielectric plastic material in which an electrical and/or digital meter is immobilized equipped at its lower part of the said meters with a box with its terminals and a connectors block **characterized in that** the connectors block (16) is a body (27) of any material having dielectric properties suitable for the voltage that is used in the 125, 220 and 380 volts low-voltage wirings, the said block (16) being a body (27) that is distributed in a front preferably prismatic part (16.1), and a likewise prismatic rear part (16.2) from the front part (16.1) and from its top base (28) are perpendicularly emerging the terminals (16.3) two phases and neutral point, A, B y C, one of which the C assigned to the neutral point, can be moved to the right and to the left of the said base (28), thanks to being able to move in the sliding slot (29) being therefore able to adapt itself to the female terminals located in the boxes (15) in the case of an analog meter (11) and, (21) in the case of a digital meter, the terminals (16.3) of the connectors block being cancelled (16) by means of the block protecting unit (40) of the said terminals (16.3).

2. SAFETY ARRANGEMENT FOR CONNECTING ELECTRICAL AND DIGITAL METERS according to the first claim **characterized in that** in the body (27) and the lateral slots (26) are provided between the front part (16.1) and the rear part (16.2) of the connectors block (16).

3. SAFETY ARRANGEMENT FOR CONNECTING ELECTRICAL AND DIGITAL METERS according to the preceding claims **characterized in that** the connectors block (16) is fit in the recess (11. 3) de la screen (11), thanks to the slots (26) in a vertical upwards motion of the connectors block (16)

4. SAFETY ARRANGEMENT FOR CONNECTING ELECTRICAL AND DIGITAL METERS according to the first claim **characterized in that** the block protecting unit (40) of terminals (16.3) shows a rather prismatic configuration, in one of its bases holes are provided to fit the male terminals (16.3) of the connector's block (16).

5. SAFETY ARRANGEMENT FOR CONNECTING ELECTRICAL AND DIGITAL METERS according to the first claim **characterized in that** the connectors block (16) *and of its front part* (16.1) *and of its top base* (28) there are cavities open at their upper part (31-32- 33), in which conventional connectors (34-35-36) are housed with an exit by the vertical rear part (38).

6. SAFETY ARRANGEMENT FOR CONNECTING ELECTRICAL AND DIGITAL METERS according to the claim 5 **characterized in that** the connectors (34- 35-36) are simple tubular ducts provided with holes in which respective screws are screwed trapping the conductive part of the phases coming from the connection of the property, building or the like and from its section of individual tap.

7. SAFETY ARRANGEMENT FOR CONNECTING ELECTRICAL AND DIGITAL METERS according to the first claim **characterized in that** to cancel the male terminals (16.3) of the connectors block (16) when an analog meter (12) or digital meter (19 is withdrawn, the protecting block unit (40), provided with the related blind holes is superposed and it is located atop of the block (16), sealing thereafter the block (16) with the block protecting unit (40) immobilizing the joint of both of them.

8. SAFETY ARRANGEMENT FOR CONNECTING ELECTRICAL AND DIGITAL METERS according to the first claim **characterized in that** the block protecting unit (40) is rather prismatic body (52) of dielectric material , in which at one of its bases, blind holes (46, 47, 48) have been provided to fit the terminals (16.3) of the connectors block (16).
